# EUROPEAN PATENT APPLICATION

(11) **EP 3 806 600 A1**
(43) Date of publication of application: **14.04.2021**
(21) Application number: 18920492.8
(22) Date of filing: 01.06.2018
(51) Int. Cl.: H05K 13/02, H05K 13/00

(54) **REPLACEMENT SYSTEM AND REPLACEMENT DEVICE**

(71) Applicant: Fuji Corporation, Chiryu-shi, Aichi 472-8686 (JP)
(72) Inventor: OYAMA Shigeto, Chiryu-shi, Aichi 472-8686 (JP); KONDO Masahiro, Chiryu-shi, Aichi 472-8686 (JP); NARITA, Haruna, Chiryu-shi, Aichi 472-8686 (JP)
(74) Representative: Grünecker Patent- und Rechtsanwälte PartG mbB
(86) International application number: PCT/JP2018/021270
(87) International publication number: WO 2019/229996

(57) **Abstract**

The replacement system comprises: a device main body configured to contain a replacement element detachably installed in a component mounting machine;
a holding portion configured to hold the replacement element and provided in the device main body so as to be movable in an attachment/detachment direction of the replacement element; a first detecting section and a second detecting section, each configured to detect the replacement element at different detection positions in the attachment/detachment direction of the replacement element; and a determination section configured to determine whether the replacement process of the replacement element between the device main body and the component mounting machine has been performed in a normal manner based on the detection result from the first detecting section and the detection result from the second detecting section.

## Description

### Technical Field

The present invention relates to replacement systems and replacement devices.

### Background Art

A replacement system consisting of a replacement device is used for replacing replacement elements which are installed in a component mounting machine. Patent Literature 1 discloses a replacement device as a replenishment device that automatically collects and replenishes feeders with a component mounting machine. Such a replacement device, for example, is capable of detecting feeders in an accommodated state with a detection sensor provided in the device main body, and, based on detection results from the detection sensor, can recognize whether a feeder is being accommodated in the device main body or has been installed in the component mounting machine.

### Patent Literature

Patent Literature 1: International Publication WO2014/010083

### Summary of the Invention

### Technical Problem

In the replacement system described above, there is a possibility that the movement of the replacement element is hindered by an unexpected situation such as the introduction of foreign matter in the movement trajectory of the replacement element in the replacement process. This may affect subsequent operations of the replacement device when the replacement element is no longer in an accommodated or installed state.

It is an object of the present specification to provide a replacement system and a replacement device capable of determining the success or failure of a replacement process by more accurately determining the state of a replacement element.

### Solution to Problem

The present specification discloses a replacement system, comprising: a device main body configured to contain a replacement element detachably installed in a component mounting machine; a holding portion configured to hold the replacement element and provided in the device main body so as to be movable in an attachment/detachment direction of the replacement element; a first detecting section and a second detecting section, each configured to detect the replacement element at different detection positions in the attachment/detachment direction of the replacement element; and a determination section configured to determine whether the replacement process of the replacement element between the device main body and the component mounting machine has been performed in a normal manner based on the detection result from the first detecting section and the detection result from the second detecting section.

The present specification discloses a replacement device, comprising: a device main body configured to contain a replacement element detachably installed in a component mounting machine; a holding portion configured to hold the replacement element and provided in the device main body so as to be movable in an attachment/detachment direction of the replacement element; a first detecting section, provided in the device main body, configured to detect the replacement element at a predetermined detection position in the attachment/detachment direction of the replacement element; and a determination section configured to determine whether the replacement process of the replacement element between the device main body and the component mounting machine has been performed in a normal manner based on the detection result from a second detecting section and the detection result from the first detecting section, the second detecting section being provided in the component mounting machine and configured to detect the replacement element at a detection position, in the attachment/detachment direction of the replacement element, different from the detection position of the first detecting section.

### Advantageous Effect of the Invention

With such a configuration, the replacement element is detected at different detection positions in the attachment/detachment direction by the first detecting section and the second detecting section. As a result, it is possible to more accurately determine the state of a replacement element undergoing a replacement process. Therefore, it is possible to determine whether a replacement process has been successful.

### Brief Description of Drawings

[Fig. 1] A perspective view showing a production line to which a replacement system of an embodiment is applied.
[Fig. 2] A perspective view showing a schematic configuration of the replacement device and the component mounting machine in Fig. 1.
[Fig. 3] A plan view schematically showing a component mounting machine and a replacement device.
[Fig. 4] A view schematically showing multiple states of a feeder with respect to a component mounting machine and a replacement device.
[Fig. 5] A flowchart showing a replacement process using a replacement device.

### Description of Embodiments

### 1. Overview of the replacement system and replacement device

An embodiment embodying a replacement system and a replacement device will be described below with reference to the accompanying drawings. The replacement system comprising the replacement device is intended for at least one of the various replacement elements provided in the component mounting machine and exchanges the replacement elements with the component mounting machine. In the present embodiment, a mode in which the replacement system is applied to a production line configured with multiple component mounting machines will be used as an example.

### 2. Configuration of production line 1

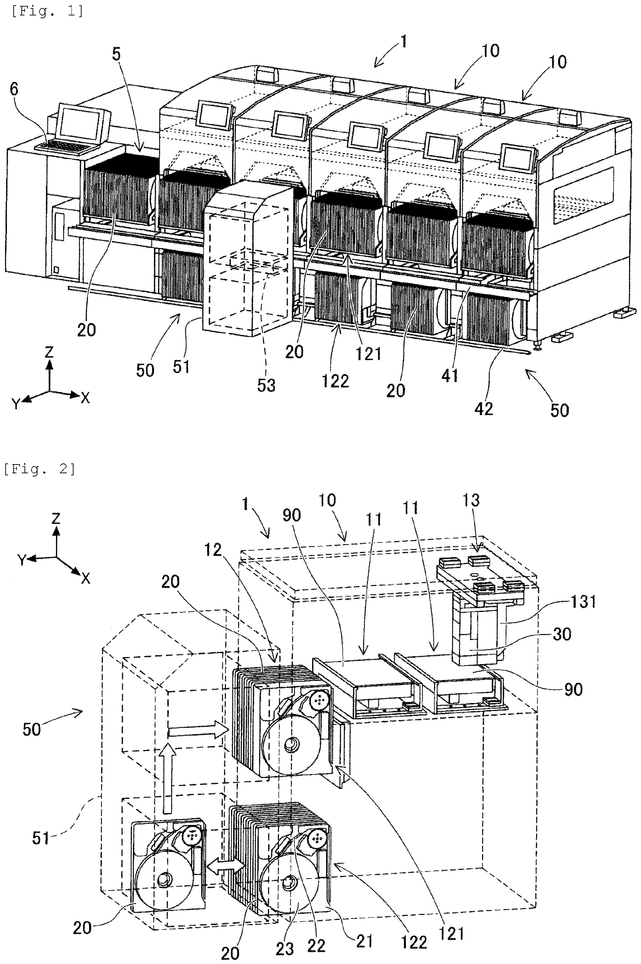

Production line 1, as shown in Fig. 1, is configured with multiple component mounting machine 10 installed side by side in the conveyance direction of board 90 (X-direction). Feeder storage device 5 used for storage of feeders 20 of the cassette type is installed at the board convey-in side of production line 1 (upper left side in Fig. 1). Production line 1 may also include, for example, screen printers, mounting inspection machines, reflow furnaces, and the like.

In the present embodiment, replacement device 50, as a work device for performing a predetermined operation on each of multiple component mounting machines 10 and feeder storage device 5, is applied to production line 1. Each of the devices constituting production line 1 and replacement device 50 are configured to input and output various data to and from management device 6 via a network (not shown). A detailed configuration of replacement device 50 will be described later.

Feeder storage device 5 has multiple slots and stocks feeders 20 set in the slots. When feeder 20 is set in feeder storage device 5, communication between feeder 20 and management device 6 is enabled. As a result, the slot of feeder storage device 5 and ID of feeder 20 set in the slot are linked to each other and recorded in management device 6.

Management device 6 monitors the operational status of production line 1 and controls the production equipment including component mounting machines 10 and feeder storage device 5. Various data for controlling component mounting machines 10 are stored in management device 6. Management device 6 transmits various data such as a control program to each piece of production equipment as appropriate when executing the production process in each piece of production equipment.

### 3. Configuration of component mounting machine 10

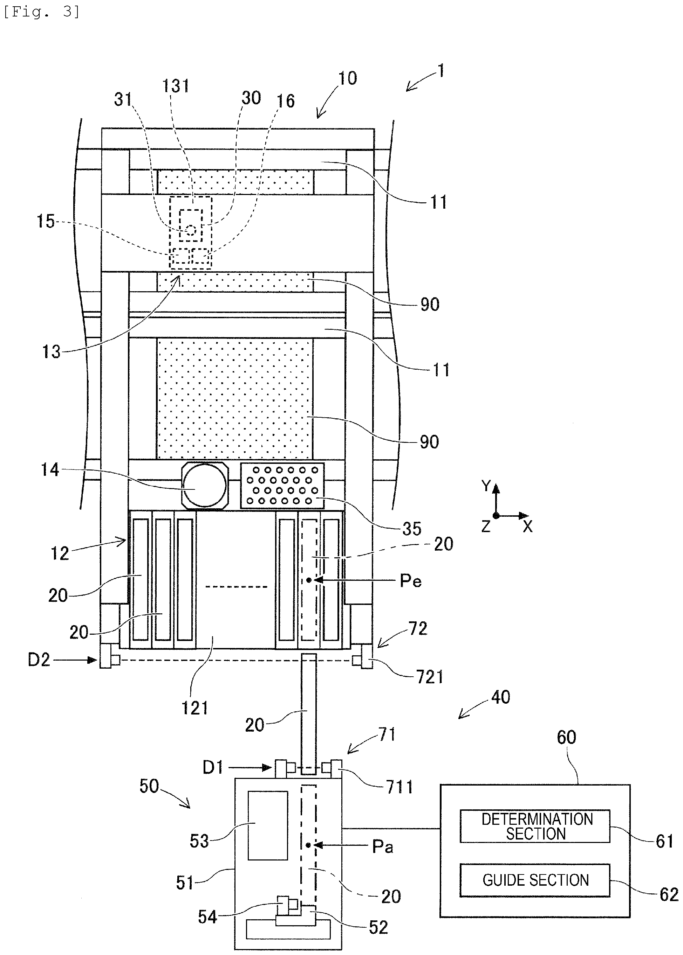

Each of multiple component mounting machines 10 constituting production line 1, as shown in Figs. 2 and 3, comprise board conveyance device 11, component supply device 12, head driving device 13, part camera 14, board camera 15, and height sensor 16. In the following description, the conveyance direction of board 90, which is the horizontal width direction of component mounting machine 10 is the X-direction, the horizontal depth direction of component mounting machine 10 is the Y-direction, the vertical direction perpendicular to the X-direction and the Y-direction (the up-down direction in Fig. 1) is the Z-direction.

Board conveyance device 11 includes a belt conveyor, a positioning device, and the like. Board conveyance device 11, together with sequentially conveying board 90 in the conveyance direction, positions board 90 at a predetermined position in the machine. Board conveyance device 11 conveys board 90 out of component mounting machine 10 after the mounting process by component mounting machine 10 is completed.

Component supply device 12 supplies a component to be mounted on board 90. Component supply device 12 has upper slots 121 and lower slots 122 which can be installed with feeders 20. Upper slots 121 are disposed on the top of the front side of component mounting machine 10 and holds installed feeders 20 in an operational manner. That is, the operation of feeders 20 installed in upper slots 121 is controlled in the mounting process in component mounting machine 10, and components are supplied from a retrieving portion provided in a predetermined position of the upper portion of feeder 20.

Lower slots 122 are located below upper slots 121 and stock installed feeders 20. That is, lower slots 122 preliminarily hold feeders 20 used in production or temporarily hold used feeders 20 that were used in production. The exchange of feeders 20 between upper slots 121 and lower slots 122 is performed by automatic exchange by replacement device 50 to be described later, or manual exchange by an operator.

Head driving device 13 transfers components supplied by component feeder 12 to a predetermined mounting position on board 90 conveyed in by board conveyance device 11. Head driving device 13 moves moving table 131 in the horizontal direction (X-axis direction and Y-axis direction) by a linear motion mechanism. Mounting head 30 is fixed to moving table 131 in an exchangeable manner by a clamp member (not shown). In addition to picking up components, mounting head 30 adjusts the up-down directional position and angle of components and mounts the components on board 90.

Specifically, a holding member for holding components supplied by feeder 20 is attached to mounting head 30. For example, suction nozzle 31 that is supplied with negative pressure and holds components, a chuck that grips and holds components, or the like can be applied to the holding member. Mounting head 30 can move the holding member in the Z-direction and can rotate the holding member around a θ axis that is parallel to the Z-axis. Mounting head 30 is moved in the XY-direction by a linear motion mechanism of head driving device 13.

Part camera 14 and board camera 15 are digital imaging devices having an imaging device such as a CMOS. Part camera 14 and board camera 15 perform imaging based on control signals and send image data acquired by the imaging. Part camera 14 is configured to image components held by suction nozzle 31 of mounting head 30 from below. Board camera 15 is configured to image board 90 from above.

Height sensor 16 is provided on moving table 131. Height sensor 16 measures the height from a target object to mounting head 30 by measuring the distance to the target object located vertically below. Height sensor 16 may be, for example, an optical sensor utilizing a laser beam. Further, the target object described above, for example, can include board 90 positioned by board conveyance device 11, components mounted on board 90, such as components supplied by component supply device 12, and the like.

Component mounting machine 10 having the above-described configuration executes a mounting process for mounting a component to board 90. In the mounting process, component mounting machine 10 sends a control signal to head driving device 13 based on the result of image processing, detection results from various sensors, a control program stored in advance, and the like. With this, the position and angle of multiple suction nozzles 31 supported by mounting head 30 are controlled.

Suction nozzle 31 to be held in mounting head 30 is appropriately changed in accordance with the type of component to be mounted on board 90 in the mounting process. Component mounting machine 10 causes mounting head 30 to pick up suction nozzle 31 accommodated in nozzle station 35 when suction nozzle 31 used in the mounting process to be executed is not held by mounting head 30. Nozzle station 35 described above is detachably installed in a predetermined position inside component mounting machine 10.

### 4. Configuration of feeder 20

Feeder 20 feeds and moves a carrier tape containing a large number of components such that components are supplied in a manner which allows the components to be picked up. Case 21 of feeder 20 has an overall rectangular shape. Case 21 detachably holds tape reel 23 on which carrier tape 22 is wound. Carrier tape 22 accommodates components in multiple cavities formed at regular intervals in the feeding direction.

Further, when feeder 20 is installed in upper slot 121 or lower slot 122 of component supply device 12, power is supplied from component mounting machine 10 via a connector. Feeder 20 is then able to communicate with component mounting machine 10. Feeder 20 controls the feeding operation of carrier tape 22 based on control instructions from component mounting machine 10 or the like. Thus, feeder 20 supplies components in a manner which allows the components to be picked up by the holding member of mounting head 30 in the retrieving portion provided at a predetermined position of the upper portion of feeder 20.

### 5. Configuration of replacement system 40 and replacement device 50

Replacement system 40 includes first rail 41, second rail 42, and replacement device 50, as shown in Figs. 1 to 3. First rail 41, as shown in Fig. 1, is provided at the front of multiple component mounting machine 10. More specifically, first rail 41 is provided between upper slots 121 and lower slots 122, in the up-down direction, upper slots 121 and lower slots 122 being provided at each of the multiple component mounting machines 10. Second rail 42 is provided below lower slots 122 of component mounting machine 10.

First rail 41 and second rail 42, configured as described above, extend over substantially the entire length of the conveyance direction of board 90 in production line 1. Thus, replacement device 50, by an operation of moving device 53 to be described later, is configured to be positioned at any position in the X-direction including the front of component mounting machines 10 and feeder storage device 5.

In the present embodiment, with feeder 20 for supplying components to be mounted on board 90 being a replacement element, replacement device 50 performs a replacement process of feeder 20 with multiple component mounting machines 10 and feeder storage device 5 which constitute production line 1. The replacement process described above includes at least one of recovery and replenishment of feeder 20.

In this embodiment, replacement device 50 conveys feeder 20 from feeder storage device 5 to upper slot 121 or lower slot 122 of component mounting machine 10. Replacement device 50 also exchanges feeder 20 between upper slot 121 and lower slot 122 of component mounting machine 10. Furthermore, replacement device 50 conveys used feeders 20 from component mounting machine 10 to feeder storage device 5.

Replacement device 50 includes, as shown in Fig. 3, device main body 51, holding portion 52, moving device 53, reference sensor 54, and control device 60. Device main body 51 accommodates feeder 20 and holds holding portion 52. Further, a driving device (not shown) for operating holding portion 52 is provided in device main body 51.

Holding portion 52 holds feeder 20. As for configurations by which holding portion 52 is to hold feeder 20, holding portion 52 can be configured to grip case 21 of feeder 20, holding portion 52 can be configured to lock a locking portion provided in case 21, holding portion 52 can be configured to connect to a connecting portion provided in case 21, and the like. Holding portion 52 is provided to device main body 51 so as to be movable in the attachment/detachment direction of feeder 20 (Y-direction in this embodiment). Further, holding portion 52 is provided so as to be movable in the Z-direction with respect to device main body 51. The YZ-direction position of holding portion 52 and holding state of feeder 20 by holding portion 52 is controlled by control device 60.

Moving device 53 moves device main body 51 along the conveyance direction of board 90 in production line 1 (X-direction in this embodiment). Moving device 53 moves device main body 51 along first rail 41 by rotating a drive wheel (not shown) which is frictionally engaged with first rail 41. As this occurs, moving device 53 maintains the orientation of device main body 51 with a guide roller (not shown) which rolls along second rail 42. The X-direction position of moving device 53 is controlled by control device 60.

Reference sensor 54 detects the accommodated state of feeder 20 in device main body 51. The "accommodated state" refers to a state in which feeder 20 is moved to accommodating position Pa in the attachment/detachment direction (Y-direction), as indicated by the one-dot chain line in Fig. 3. In the present embodiment, reference sensor 54 is a proximity sensor provided to holding portion 52. In a non-contact manner, reference sensor 54 detects feeder 20 moved to accommodating position Pa. Reference sensor 54 does not detect feeder 20 in the case where feeder 20 in the attachment/detachment direction of feeder 20 is positioned deviated from accommodating position Pa and in the case where holding portion 52 does not hold feeder 20.

Control device 60 is a controller mainly composed of a CPU, various types of memory, and a control circuit. Control device 60 is communicatively connected to multiple component mounting machines 10, feeder storage device 5, and management device 6. Control device 60 operates the driving device for operating moving device 53 and holding portion 52 based on the X-direction position of device main body 51, the YZ direction position of holding portion 52, the holding state of feeder 20, and the like. Thus, control device 60 controls the replacement process of feeder 20 by replacement device 50.

When replacement process of feeder 20 by replacement device 50 is performed in a normal manner, feeder 20 assumes a state of being accommodated in device main body 51 or a state of being installed in component mounting machine 10. The above "installed state", as shown by the two-dot chain line in Fig. 3, refers to a state in which feeder 20 is moved to installation position Pe in the attachment/detachment direction (Y-direction). After performing the replacement process, control device 60 recognizes whether feeder 20 is positioned in accommodating position Pa based on the detection result from reference sensor 54.

However, if a component or waste that has fallen off carrier tape 22 as foreign matter become incorporated in the movement trajectory of feeder 20, the movement of feeder 20 may be obstructed. Further, when a feeder 20 recovered by the replacement process is obstructed by an adjacent feeder 20, there is a possibility that the adjacent feeder 20 will move from installation position Pe slightly toward the accommodating position Pa side. In the case described above, whether the replacement process has been performed in a normal manner may not be accurately determined depending on whether the replacement target feeder 20 is located at accommodating position Pa.

Therefore, replacement system 40 is configured to detect feeder 20 at different detection positions from each other in the attachment/detachment direction of feeder 20 and determine whether the replacement process has been performed in a normal manner based on the detection result. Specifically, replacement system 40 includes first detecting section 71, second detecting section 72, determination section 61, and guide section 62. First detecting section 71 and second detecting section 72 detect feeder 20 at detection positions D1,D2 different from each other in the attachment/detachment direction of feeder 20.

Specifically, first detecting section 71 has optical sensor 711 as a first sensor provided in device main body 51. Similarly, second detecting section 72 has optical sensor 721 as a second sensor provided in component mounting machine 10. optical sensors 711,721 receive light emitted in a direction (X-direction in this embodiment) intersecting the attachment/detachment direction of feeder 20 and detect the presence/absence of feeder 20 in the detection position.

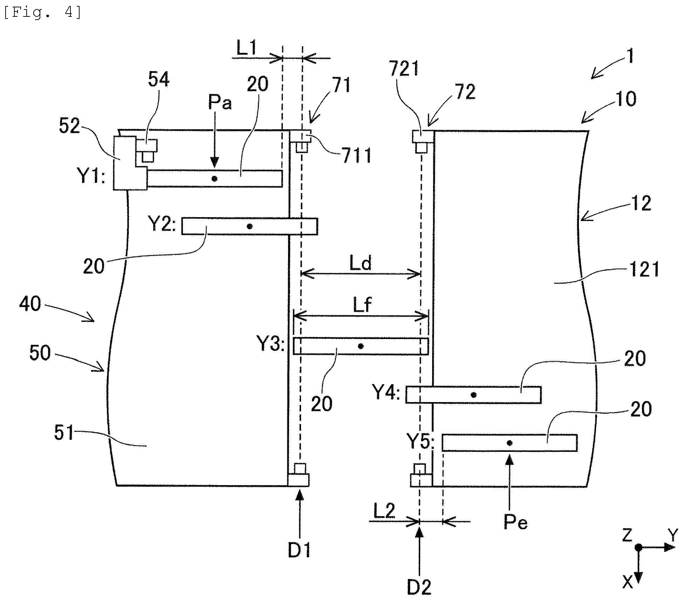

Specifically, optical sensor 711 of first detecting section 71 detects feeder 20 at first detection position D1 separated by predetermined distance L1 toward the installation position Pe side from the end of feeder 20 located at accommodating position Pa (refer to states Y1,Y2 in Fig. 4). optical sensor 721 of second detecting section 72 detects feeder 20 at second detection position D2 separated by predetermined distance L2 toward the accommodating position Pa side from the end of feeder 20 located at installation position Pe (refer to states Y4,Y5 in Fig. 4).

With such a configuration, first detecting section 71 detects any protrusion of feeder 20 from device main body 51. Further, second detecting section 72 detects any protrusion of feeder 20 from component mounting machine 10. The detection width of optical sensor 721 of second detecting section 72 is set wider than the X-direction width of upper slots 121. Thus, second detecting section 72 is configured to detect feeder 20 protruding from any one of upper slots 121.

Further, in the attachment/detachment direction of feeder 20, distance Ld between first detection position D1 and second detection position D2 is set smaller than length Lf of feeder 20. With such a configuration, it is possible to eliminate a space in which feeder 20 cannot be detected by first detection position D1 and second detection position D2. In other words, when feeder 20 is not positioned in any of accommodating position Pa and installation position Pe, feeder 20 is detected by at least one of first detecting section 71 and second detecting section 72.

In the present embodiment, as shown in Fig. 3, determination section 61 and guide section 62 are incorporated in control device 60 of replacement device 50. Determination section 61 determines whether the replacement process of feeder 20 between device main body 51 and component mounting machine 10 has been performed in a normal manner based on the detection result from first detecting section 71 and the detection result from second detecting section 72. More specifically, determination section 61 determines that the replacement process has been abnormally terminated without having been performed in a normal manner in the case where only first detecting section 71 detects feeder 20 as shown in state Y2 of Fig. 4; in the case where both first detecting section 71 and second detecting section 72 detect feeder 20 as shown in state Y3 of Fig. 4; and in the case where only second detecting section 72 detects feeder 20 as shown in state Y4 of Fig. 4.

On the other hand, as shown in state Y1 and state Y5 of Fig. 4, determination section 61 determines that the replacement process has been performed in a normal manner when both the detection result from first detecting section 71 and the detection result from second detecting section 72 indicate that feeder 20 is not detected. Fig. 4 displays each of the states of the same feeder 20 shifted in the X-direction. Therefore, the X-direction positions of feeders 20 in the states Y1 to Y5 of Fig. 4 are the same.

Guide section 62 notifies the operator of the state of feeder 20 recognized based on the detection result from first detecting section 71 and the detection result from second detecting section 72 in the case where determining section 61 determines that the replacement process of feeder 20 has not been performed in a normal manner. The above "state of feeder 20" includes the position of feeder 20 in the attachment/detachment direction, whether holding portion 52 holds feeder 20, whether feeder 20 is communicable with component mounting machine 10, and the like.

In the present embodiment, guide section 62 indicates the position of feeder 20 to be determined based on the detection result from first detecting section 71 and the detection result from second detecting section 72. In addition to or in place of the state of feeder 20 as described above, guide section 62 may notify the operator with error processing information. The information of error processing indicates restoration work or the like for the replacement process which has been abnormally terminated, and is changed in accordance with the state of feeder 20.

Guide section 62 may display guidance information on management device 6 or display guidance information on a terminal device such as a portable terminal (smartphone, tablet) held by an operator. With the above-described configuration, the operator can determine what kind of restoration work should be performed. As a result, it is possible to shorten any stopping time of replacement device 50 which occurs when the replacement process has been abnormally terminated. As a result, a decrease in production efficiency can be prevented.

### 6. Replacement process by the replacement system

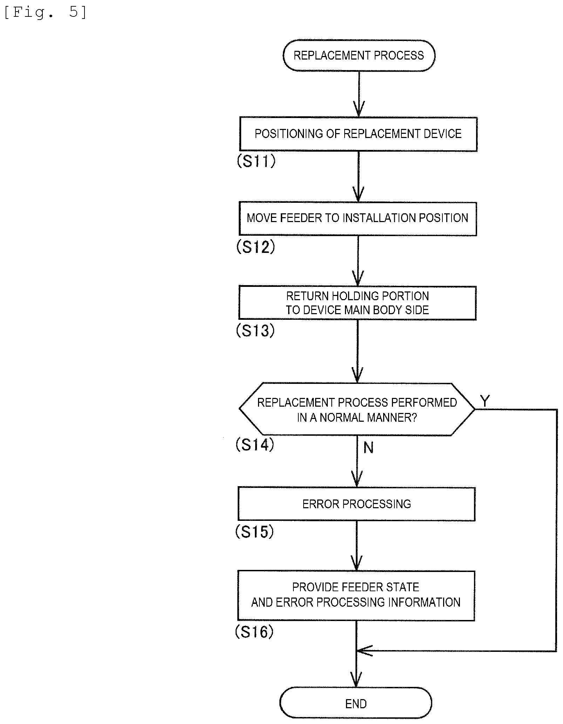

The replacement process by the replacement system will be described with reference to Figs. 4 and 5. Here, the replacement element which is the target of the replacement process is feeder 20 which is installed in component mounting machine 10 in the same manner as described above. Further, the replacement process includes a replenishment operation of installing feeder 20 from device main body 51 of replacement device 50 to upper slot 121 or lower slot 122 of component supply device 12, and, conversely, a recovery operation of withdrawing feeder 20 from component supply device 12 by device main body 51. The replenishment operation in the replacement process will now be described.

Further, replacement device 50 puts feeder 20 from feeder storage device 5 or lower slot 122 of component supply device 12 into an accommodated state in device main body 51, feeder 20 being scheduled for installation. Control device 60 recognizes that feeder 20 is in a normal accommodated state based on reference sensor 54 detecting feeder 20 held by holding portion 52 and the two optical sensors 711,721 not detecting feeder 20.

As shown in Fig. 5, control device 60 first performs positioning of replacement device 50 (S11). Specifically, control device 60 causes moving device 53 to operate based on the current position of replacement device 50 in the X-direction. As a result, feeder 20 held by holding portion 52 is positioned corresponding to the position of upper slot 121 scheduled for installation. Next, control device 60 causes holding portion 52 to operate, causing feeder 20 held by holding portion 52 to move to installation position Pe (S12).

Subsequently, control device 60 releases the holding of feeder 20 by holding portion 52 and returns holding portion 52 to the device main body 51 side (S13). Determination section 61 determines whether the replacement process of feeder 20 between device main body 51 and component mounting machine 10 has been performed in a normal manner based on the detection result from first detecting section 71 and the detection result from second detecting section 72 (S14). Specifically, assuming that reference sensor 54 does not detect feeder 20 because the replenishment operation has been performed, in the case where first detecting section 71 and second detecting section 72 both do not detect feeder 20 (state Y1 or state Y5 in Fig. 4), determination section 61 determines that the replacement process has been performed in a normal manner (S14: Yes).

On the other hand, in the case where at least one of first detecting section 71 and second detecting section 72 detects feeder 20 (states Y2,Y3,Y4 in Fig. 4), determination section 61 determines that the replacement process has been abnormally terminated without having been performed in a normal manner (S14: No). Control device 60 executes error processing in the case where the replacement process has been abnormally terminated (S15). In the present embodiment, as a result of the above error processing, operation from the current state is restricted in replacement device 50 together with the stopping of operation of holding portion 52 and moving device 53.

Further, guide section 62 provides the state of feeder 20 and information on error processing (S16). Specifically, with the state of feeder 20 being the position of feeder 20 calculated based on the detection result from first detecting section 71 and the detection result from second detecting section 72, guide section 62 provides the operator with the position of feeder 20 in the installation operation of the replacement process. Furthermore, guide section 62 suggests restoration work in accordance with the state of feeder 20.

### 7. Effects of the configuration of the embodiment

Replacement system 40 comprises: device main body 51 configured to contain a replacement element (feeder 20) detachably installed in component mounting machine 10; holding portion 52 configured to hold the replacement element and provided in device main body 51 so as to be movable in the attachment/detachment direction of the replacement element; first detecting section 71 and second detecting section 72, each configured to detect the replacement element at different detection positions in the attachment/detachment direction of the replacement element; and determination section 61 configured to determine whether the replacement process of the replacement element between device main body 51 and component mounting machine 10 has been performed in a normal manner based on the detection result of first detecting section 71 and the detection result of second detecting section 72.

Further, replacement device 50, comprises: device main body 51 configured to contain a replacement element (feeder 20) detachably installed in component mounting machine 10; holding portion 52 configured to hold the replacement element and provided in device main body 51 so as to be movable in the attachment/detachment direction of the replacement element; first detecting section 71, provided in device main body 51, configured to detect the replacement element at a predetermined detection position in the attachment/detachment direction of the replacement element; determination section 61 configured to determine whether the replacement process of the replacement element between device main body 51 and component mounting machine 10 has been performed in a normal manner based on the detection result of second detecting section 72 and the detection result from first detecting section 71, second detecting section 72 being provided in component mounting machine 10 and configured to detect the replacement element at a detection position, in the attachment/detachment direction of the replacement element, different from the detection position of first detecting section 71.

With such a configuration, the replacement element (feeder 20) is detected at different detection positions D1, D2 in the attachment/detachment direction by first detecting section 71 and second detecting section 72. Thus, as compared with a configuration in which only the accommodated state is detected as in the prior art, it is possible to more accurately determine the state of feeder 20, which is a replacement element, by the execution of the replacement process. Therefore, it is possible to determine whether a replacement process has been successful.

### 8. Variation of the embodiment

### 8-1. Regarding first detecting section 71 and second detecting section 72

In the embodiment, the configuration described is one in which first detecting section 71 is provided in device main body 51 of replacement device 50 and second detecting section 72 is provided in component mounting machine 10. In contrast to this, first detecting section 71 and second detecting section 72 may adopt various modes as long as they can detect feeder 20 at detection positions D1 ,D2 different from each other in the attachment/detachment direction of feeder 20.

For example, both first detecting section 71 and second detecting section 72 may be provided in replacement device 50. Thus, in a configuration in which replacement device 50 is provided with moving device 53, it is possible to share first detecting section 71 and second detecting section 72 in the replacement process among multiple component mounting machines 10 and feeder storage device 5. Further, first detecting section 71 and second detecting section 72 may be provided in component mounting machine 10. As a result, the positional relationship between first detecting section 71 and second detecting section 72 is fixed, and detection accuracy can be improved.

Further, in the embodiment, first detecting section 71 and second detecting section 72 have optical sensors 711,721. In contrast to this, first detecting section 71 and second detecting section 72 may be configured to have a contact sensor or an ultrasonic sensor. Second detecting section 72 may be configured as a second sensor in component mounting machine 10 and serve as height sensor 16 of component mounting machine 10.

Specifically, at the time of executing the replacement process, replacement device 50 makes a request to component mounting machine 10 so that height sensor 16 is moved to a position above feeder 20 and detects the height of feeder 20. When this occurs, for example, second detection position D2 may be a position shifted toward the accommodating position Pa side from feeder 20 positioned at installation position Pe. Second detecting section 72 then detects feeder 20 based on the detection result of height sensor 16. With such a configuration, the same effect as that of the embodiment can be obtained. Further, since the existing height sensor 16 can be repurposed, it is possible to reduce the equipment cost.

In addition to the above, first detecting section 71 and second detecting section 72 may detect feeder 20 based on the result of image processing. Specifically, instead of optical sensors 711,721, first detecting section 71 and second detecting section 72 detect feeder 20 by image processing image data acquired by imaging with a camera including the detection position in the camera field of view. As a result, determination section 61 can recognize the state of feeder 20. Incidentally, board camera 15 provided on moving table 131 of head driving device 13 may be used for the camera described above.

In addition, second detecting section 72 may detect feeder 20 based on the result of the determination as to whether component mounting machine 10 and feeder 20 can communicate with each other. However, when determining whether the replenishment operation of the replacement process has been performed in a normal manner, since feeder 20 is powered and activated by being installed in upper slot 121, it takes a certain amount of time to establish communication with component mounting machine 10. Therefore, from the viewpoint of immediately determining whether the replacement process has been performed in a normal manner, the example demonstrated by the embodiment is preferred.

In addition, in the embodiment, in order to simplify the description, replacement system 40 is configured to include two detecting sections, that is, first detecting section 71 and second detecting section 72. In contrast, replacement system 40 may include three or more detecting sections and recognize the state of feeder 20 based on the respective detection results. Further, the detection result of reference sensor 54 may be used to determine whether the replacement process has been performed in a normal manner.

### 8-2. Replacement elements

In the embodiment, the replacement element which is the replacement target of replacement system 40 and replacement device 50 was assumed to be feeder 20 which is installed in component mounting machine 10 and supplies components to be mounted on board 90. In contrast to this, the replacement element of replacement system 40 and replacement device 50 may be other than feeder 20. Specifically, for example, tape reel 23, nozzle station 35, waste tape receptacle, and the like that are installed in component mounting machine 10 can be replacement elements.

There is a type of feeder in which the reel holder for holding tape reel 23 is disposed outside. In this case, replacement device 50 automatically replaces tape reel 23 of feeder, thereby enabling accurate delivery of the tape reel. Further, nozzle stations are required to hold suction nozzles 31 corresponding to the type of component used in the production of a board product. Therefore, production efficiency in production line 1 can be improved by placing a storage device for the nozzle station in production line 1 and automatically exchanging the nozzle station between the storage device and component mounting machine 10.

Further, a waste tape receptacle is provided below upper slot 121 of component mounting machine 10 and, for example, collects waste tape generated when each of feeders 20 supplies components. The waste tape is, for example, a portion of carrier tape 22, from which components have been taken out, cut to an appropriate length. The capacity of the waste tape receptacle is limited. Therefore, it is useful from the viewpoint of maintaining a good production state to use replacement device 50, for example, to maintain the amount of the waste tape collected with the waste tape receptacle at a constant level or less.

In addition, replacement device 50 may be configured to supply a stick and recover an empty stick when feeder 20 is a stick feeder. Further, when feeder 20 is a bulk feeder, replacement device 50 may be configured to supply bulk components or may be configured to supply component cases for accommodating bulk components and recover empty component cases. Even in such a configuration, it is possible to automatically replenish and recover the replacement element, and improve the production efficiency in production line 1.

### 8-3. Other

In the embodiment, control device 60 of replacement device 50 is configured to execute error processing (S15) when the replacement process is not performed in a normal manner (S14: No). In contrast to this, in error processing, control device 60 may execute the recovery process in addition to stopping operation of component mounting device 10 and replacement device 50. The above recovery process, for example, in accordance with the state of feeder 20 based on the detection result from first detecting section 71 and the detection result from second detecting section 72, and includes the operation of attempting to move feeder 20 again to accommodating position Pa or installation position Pe.

Incidentally, feeder 20 adjacent to feeder 20 recovered in the recovery operation of the replacement process is moved by being obstructed and it is assumed that the replacement process is abnormally terminated. In this case, the recovered feeder 20 is not detected by first detecting section 71 but is detected by reference sensor 54. Further, the adjacent feeder 20 which has been moved by being obstructed is detected by second detecting section 72. As a result, determination section 61 determines that the replacement process has not been performed in a normal manner.

In such a case, which feeder 20 installed in upper slot 121 cannot be identified from only the detection result of second detecting section 72 which performs detection with optical sensor 721. Therefore, in error processing in the case where the recovery operation of the replacement process is abnormally terminated, control device 60 may identify feeder 20 moved from installation position Pe by image processing image data acquired by imaging with board camera 15 provided to moving table 131 or by acquiring a detection result from height sensor 16. As a result, the recovery process can be performed more reliably, and guide section 62 can accurately present feeder 20 that has resulted in an error to the operator.

Further, after error processing including the recovery process as described above is executed, guide section 62 may acquire the detection result from first detecting section 71 and the detection result from second detecting section 72 again and present the state of feeder 20 based on these. Specifically, guide section 62 notifies the operator with identification information, the state, the operational availability of moving device 53, and the like of feeder 20 as guidance information. In addition, guide section 62 may omit the guidance process, for example, when the error in the replacement process is resolved by the recovery process.

In the present embodiment, determination section 61 and guide section 62 are configured to be incorporated in control device 60 of replacement device 50. In contrast to this, if it is possible to acquire the detection result from first detecting section 71 and the detection result from second detecting section 72, determination section 61 and guide section 62, for example, may be configured to be incorporated into feeder storage device 5 communicably connected to replacement device 50 or management device 6 of production line 1.

Further, in the present embodiment, replacement device 50 is configured to be applied to production line 1 constituted by multiple component mounting machine 10. In contrast to this, replacement device 50 may be installed as a dedicated device for one component mounting machine 10 and configured to exchange feeder 20 between upper slot 121 and lower slot 122. In this case, replacement device 50 achieves the same effect even if the replacement element is other than feeder 20, as described above.

### Reference Signs List

1: Production line, 5: Feeder storage device, 6: Management device, 10: Component mounting machine, 12: Component supply device, 121: Upper slot, 122: Lower slot, 16: Height sensor, 20: Feeder (replacement element), 30: Mounting head, 40: Replacement system, 50: Replacement device, 51: Device main body, 52: Holding portion, 53: Moving device, 54: Reference sensor, 60: Control device, 61: Determination section, 62: Guide section, 71: First detecting section, 711: optical sensor (first sensor), 72: Second detecting section, 721: optical sensor (second sensor), 90: Board, Pa: Accommodating position, Pe: Installation position, D1: First detection position, D2: Second detection position, L1,L2: Predetermined distance, Lf: Length (of the feeder)

## Claims

1. A replacement system, comprising:
a device main body configured to contain a replacement element detachably installed in a component mounting machine;
a holding portion configured to hold the replacement element and provided in the device main body so as to be movable in an attachment/detachment direction of the replacement element;
a first detecting section and a second detecting section, each configured to detect the replacement element at different detection positions in the attachment/detachment direction of the replacement element; and
a determination section configured to determine whether the replacement process of the replacement element between the device main body and the component mounting machine has been performed in a normal manner based on the detection result from the first detecting section and the detection result from the second detecting section.

2. The replacement system of claim 1, wherein
the first detecting section detects the replacement element at a first detection position spaced a predetermined distance from an accommodating position of the replacement element in the device main body toward an installation position side of the replacement element in the component mounting machine, and
the second detecting section detects the replacement element at a second detection position spaced a predetermined distance toward the accommodation position side from an installation position.

3. The replacement system of claim 2, wherein the distance between the first detection position and the second detection position in the attachment/detachment direction of the replacement element is set to be less than the length of the replacement element.

4. The replacement system of any one of claims 1 to 3, wherein
the first detecting section is provided in the device main body and has a first sensor configured to detect the replacement element, and
the second detecting section is provided in the component mounting machine and has a second sensor configured to detect the replacement element.

5. The replacement system of claim 4, wherein the first sensor is an optical sensor configured to detect the presence/absence of the replacement element at a detection position by receiving light emitted in a direction intersecting the attachment/detachment direction of the replacement element.

6. The replacement system of claim 4 or 5, wherein the second sensor is provided on a moving table to which a mounting head configured to move a component when the component mounting machine mounts the component on a board is mounted, and the second sensor is a height sensor configured to detect the height of the board.

7. The replacement system of any one of claims 1 to 6, further comprising:
a guide section configured to notify an operator of the state of the replacement element recognized based on the detection result of the first detecting section and the detection result of the second detecting section when it is determined by the determination section that the replacement process of the replacement element has not been performed in a normal manner.

8. The replacement system of any one of claims 1 to 7, wherein
the replacement system is applied to a production line in which multiple component mounting machines are installed side by side,
the replacement system further comprising a moving device for moving the device main body along a board conveyance direction in the production line.

9. The replacement system of any one of claims 1 to 8, wherein
the replacement element is a feeder configured to supply components to be mounted on a board, and
the replacement system performs the replacement process of the feeder with each of the multiple component mounting machines.

10. A replacement device, comprising:
a device main body configured to contain a replacement element detachably installed in a component mounting machine;
a holding portion configured to hold the replacement element and provided in the device main body so as to be movable in an attachment/detachment direction of the replacement element;
a first detecting section, provided in the device main body, configured to detect the replacement element at a predetermined detection position in the attachment/detachment direction of the replacement element; and
a determination section configured to determine whether the replacement process of the replacement element between the device main body and the component mounting machine has been performed in a normal manner based on the detection result from a second detecting section and the detection result from the first detecting section, the second detecting section being provided in the component mounting machine and configured to detect the replacement element at a detection position, in the attachment/detachment direction of the replacement element, different from the detection position of the first detecting section.
